# EUROPÄISCHE PATENTSCHRIFT

(11) **EP 1 543 707 B1**
(45) Veröffentlichungstag und Bekanntmachung des Hinweises auf die Patenterteilung: **07.05.2008**
(21) Anmeldenummer: 03807766.5
(22) Anmeldetag: 31.07.2003
(51) Int. Cl.: H05K 7/14

(54) **BAUGRUPPENTRÄGER**
MODULE CARRIER
CHASSIS

(30) Priorität: 27.09.2002 DE 10245120
(43) Veröffentlichungstag der Anmeldung: 22.06.2005
(73) Patentinhaber: SIEMENS AKTIENGESELLSCHAFT, 80333 München (DE)
(72) Erfinder: GERLICH, Walter, 86179 Augsburg (DE)
(74) Vertreter: Maier, Daniel Oliver
(86) Internationale Anmeldenummer: PCT/EP2003/008467
(87) Internationale Veröffentlichungsnummer: WO 2004/034762

(56) Entgegenhaltungen:
- EP-A- 0 579 859
- DE-U- 29 819 968
- US-B1- 6 238 025

## Beschreibung

### Technisches Gebiet

Die Erfindung betrifft einen Baugruppenträger für auf Führungsrosten vorderseitig und/oder rückseitig in einen Einbauraum einschiebbaren Baugruppen, wobei die Führungsroste gegenüberliegende Begrenzungswände des Einbauraums bilden und jeweils baugruppenträgerseitige Kontakt- und Verbindungsvorrichtungen umfassen.

### Stand der Technik

Baugruppenträger zur Aufnahme von elektrischen und/oder elektronischen Baugruppen sind in verschiedenen Ausführungsformen bekannt. In der einfachsten Ausführungsform besteht ein Baugruppenträger in der 19"-Bauweise aus zwei seitlichen Begrenzungswänden und vier Modulschienen, die stirnseitig mit den Innenflächen der Begrenzungswände verschraubt sind. Die Leiterplatten werden in Führungsschienen eingeschoben und in Eingriff mit Steckverbinderstiften auf einer Rückwand- oder Zwischenwandkarte des Baugruppenträgers gebracht. Bei Steckverbindern mit einer hohen Anzahl von Steckverbinderstiften muss die Leiterplatte beim Einstecken sehr genau geführt werden und es sind entsprechend hohe Einsteck- und Ausziehkräfte aufzuwenden, weshalb an der Frontplatte der Baugruppe zumeist ein Steck- und Ziehhebelmechanismus angebracht ist, welcher das Ein- und Ausheben einer Baugruppe erleichtert. In eingeschobener Stellung wird die Baugruppe zumeist mittels Schrauben an einem Gewindelochstreifen befestigt. Der Gewindelochstreifen ist üblicherweise in einer vorderen Modulschiene in einer zur Vorderseite des Baugruppenträgers hin offenen Nut untergebracht.

Im Allgemeinen ist die Bauweise dieser 19"-Baugruppenträger durch die Norm EN 60297 vorgegeben. Sie gibt Maßfestlegungen für die Ausführung verschiedener funktioneller Einrichtungen, wie beispielsweise die Führung und die Befestigung der Leiterplatten, die Kodierung der Steckplätze sowie die Kontakteinrichtungen zum Schutz einer Baugruppe vor elektrostatischer Entladung.
Die Norm enthält aber auch konstruktive Einzelheiten der Funktionseinheiten, dies sowohl für die baugruppenträgerseitigen als auch für die baugruppenseitigen Funktionseinheiten. Handelsübliche Baugruppenträger folgen weitgehend den in der Norm dargestellten Ausführungseinzelheiten. Folge davon ist eine aufwendige Profil- und Führungskonstruktion, bestehend aus einer Vielzahl von Einzelbauteilen. Nur sehr eingeschränkt können bei der Herstellung vorgefertigte Baueinheiten verwendet werden. Dies macht die Fertigung aufwendig. Die ohmschen Übergangswiderstände zwischen den Einzelteilen können für eine effektive HF-Abschirmung problematisch sein.

Ein abgeschirmter Baugruppenträger ist beispielsweise aus DE 196 44 414 bekannt. Um hochfrequente Störfelder beim Durchtreten im Bereich der Frontplatte besser abschirmen zu können, werden Kontaktfederbänder mit Kontaktkrallen vorgeschlagen, die einen niederohmigen und zuverlässigen Übergangswiderstand zur Modulschiene des Trägers herstellen.

Andere Baugruppenträger sind in DE 298 19 968 U und in EP 0 579 859 offenbart.

Um enge Montagetoleranzen, insbesondere bei hochpolaren Steckern einzuhalten, wird in DE 196 44 419 zur Befestigung der Modulschiene und der Seitenteile eine spezielle Konstruktion der Befestigungsschrauben vorgeschlagen.

### Darstellung der Erfindung

Aufgabe der Erfindung ist es, einen Baugruppenträger vorzuschlagen, der weniger Einzelteile aufweist und dessen Herstellung einfacher möglich ist.

Diese Aufgabe wird erfindungsgemäß bei einem Baugruppenträger der eingangs genannten Art mit den Merkmalen des Patentanspruchs 1 gelöst. Auf vorteilhafte Ausgestaltungen der Erfindung nehmen die Unteransprüche Bezug.

Die Erfindung schlägt vor, Funktionseinheiten, wie sie für baugruppenträgerseitige Einrichtungen in der Norm EN 60297 vorgegeben sind, weitgehend in die Führungsrostkonstruktion zu integrieren. Dadurch besteht der Baugruppenträger aus wenigen Einzelteilen. Dies verringert den Aufwand bei der Montage. Da Einzelteile wegfallen, entfallen auch ohmsche Übergangwiderstände zwischen den Einzelteilen. Dies führt dazu, dass jene Funktionseinheit, welche die Baugruppe vor elektrostatischer Entladung schützt, zuverlässiger ausgeführt werden kann. Gemäß der Erfindung sind die Führungsroste einstückig mit einer integrierten Profilierung ausgebildet. Die Profilierung weist Vorsprünge auf, die in den Einbauraum ragen. Im Bereich der Einschuböffnung sind erste Vorsprünge angeordnet, die sich quer zur Einschubrichtung erstrecken. Diese ersten Vorsprünge sind mit Ausnehmungen und Löchern versehen, die zur Kontaktierung und zur Befestigung der Baugruppe im Träger dienen.

Zweckmäßiger weise sind diese ersten Vorsprünge fluchtend im Bereich der Einschuböffnung angeordnet.

Eine bevorzugte Ausführung der Erfindung ist dadurch gekennzeichnet, dass einem Steckplatz einer Baugruppe an jedem Führungsrost jeweils ein erster Vorsprung zugeordnet ist.

Bevorzugt ist eine Bauweise, bei der jeweils einem Steckplatz einer Baugruppe ein Vorsprung zugeordnet ist und dieser Vorsprung folgende Ausnehmungen aufweist:
- ein Zentrierloch, das in eingesteckter Stellung der Baugruppe eine Aufnahme für einen baugruppenseitigen zylindrischen Kontakt- /Führungsstift bildet,
- rechteckförmige Durchbrechungen, die als Kodierungskammern ausgebildet sind und beim Einstecken mit einer Baugruppenkodierung so zusammenwirken, dass Baugruppen funktional bestimmten Steckplätzen zugeordnet werden können,
- eine zur Baugruppe hin geöffnete Ausbrechung, die beim Einschieben der Baugruppe und vor dem Eingriff der Steckverbinderstift eine Entladungsleiterbahn der Leiterplatte kontaktiert, um die Baugruppe vor elektrostatischen Entladungen zu schützen.
Durch diese Konstruktion ist gewährleistet, dass der Kontakt- und Führungsstift bereits beim Einschieben, d.h. bevor der Steckverbinder der Rückwand- oder Zwischenwandleiterplatte in Eingriff kommt, einen elektrischen Kontakt mit dem Baugruppenträger herstellt. Der damit einhergehende Potentialausgleich zwischen Baugruppe und Baugruppenträger verringert das Risiko einer unerwünschten elektrostatischen Entladung, die elektronische Bauelemente auf der Leiterplatte der Baugruppe schädigen könnte. Der Schlüssel-Schlossmechanismus der Kodierungskammern stellt sicher, dass eine Baugruppe nur an einem zugeordneten Steckplatz eingesteckt werden kann.

Eine weitere vorteilhafte Ausgestaltung der Erfindung ist dadurch gekennzeichnet, dass die Profilierung zweite Vorsprünge umfasst, die sich in der Einschubrichtung erstrecken. Diese zweiten Vorsprünge bilden eine Längsführung, die das Einstecken der Baugruppe erleichtert.

Von Vorteil ist, wenn der Führungsrost einschubseitig durch eine L-förmige Winkelleiste fortgesetzt ist, wobei ein in Ebene der Einschuböffnung liegender Schenkel einen Anschlag für die Frontplatte der Baugruppe bildet. Auf diese L-förmige Winkelleiste kann die Frontplatte mittels Gewindestiften direkt verschraubt werden. Da herkömmliche Gewindeleisten wegfallen, fallen auch Übergangswiderstände weg, wodurch bei einer geschirmten Ausführung eines Baugruppenträgers dessen Abschirmeffizienz besser ist.

Bevorzugt ist ferner eine Ausführungsform, bei der der sich in Einschubrichtung erstreckende Schenkel der Winkelleiste Durchbrüche aufweist, in welche in eingesteckter Stellung ein Steck- und Ziehhebelmechanismus der Baugruppe eingreift. Dadurch ist der Einschub auf einfache Weise im Träger arretierbar.

Mit geringen Kosten kann ein Führungsrost hergestellt werden, der aus einem Stück gebildet ist und materialeinheitlich als Biege-Stanzteil aus Stahlblech hergestellt ist. Je nach Einsatzort kann es vorteilhaft sein, den gestanzten Führungsrost durch eine Beschichtung vor Korrosion zu schützen.

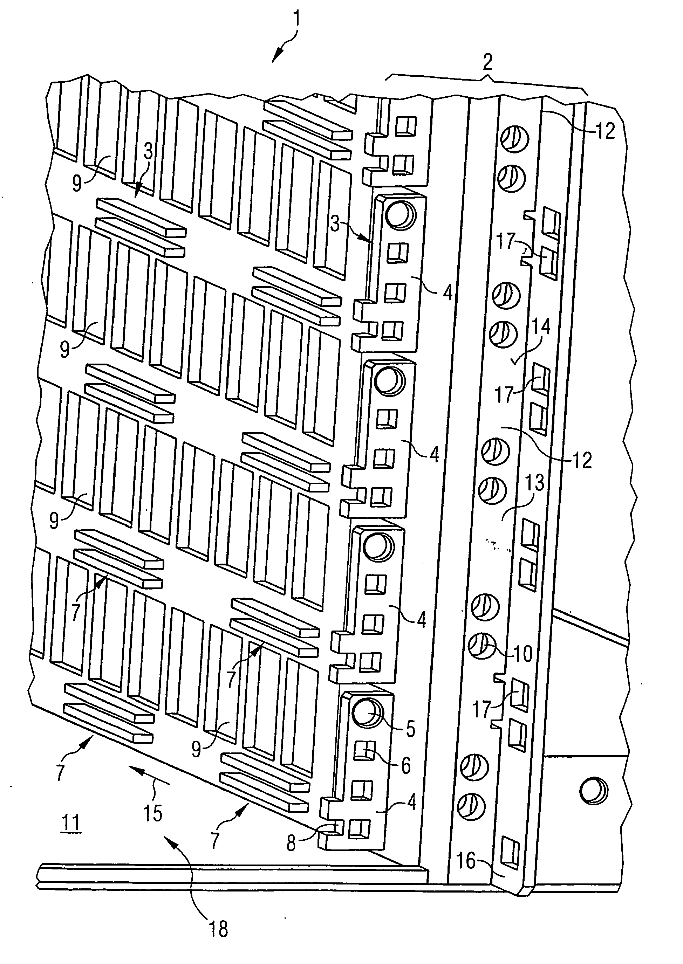

### Kurzbeschreibung der Zeichnung

Zur weiteren Erläuterung der Erfindung wird auf die Zeichnung Bezug genommen. In der einzigen Figur der Zeichnung ist eine Ausführungsform gemäß der Erfindung in einer vergrößerten Darstellung im Bereich der Einschuböffnung des rechten Führungsrostes dargestellt.

### Ausführung der Erfindung

Die Figur zeigt einen Baugruppenträger, der für Baugruppen in horizontaler Einbaulage konstruiert ist und in dessen seitlichen Führungsrost 1 unterschiedliche Funktionseinheiten der Einrichtungen der Norm EC/EN/DIN 60297 integriert sind. Die Darstellung zeigt mit Blick in die Einschuböffnung 18 eine Ausschnitt des rechten Führungsrostes 1 mit einer Profilierung 3. Die Profilierung 3 weist erste Vorsprünge 4 und zweiten Vorsprüngen 7 auf. Die Vorsprünge 4 und 7 stehen von der Ebene des Führungsrostes ab und ragen in den Einbauraum 11. Der Führungsrost 1 ist ein Biegestanzteil, das aus Blech geprägt bzw. ausgestanzt wurde.

Zunächst sei auf einen Teil des Profils 3, auf die ersten Vorsprünge 4, verwiesen. Die ersten Vorsprünge 4 sind im Randbereich der Einschuböffnung 18 fluchtend angeordnet und verlaufen quer zur Einschubrichtung 15, in der Zeichnung von oben nach unten. Jedem Einsteckplatz ist ein Vorsprung 4 zugeordnet. Jeder Vorsprung 4 weist eine Reihe von Ausnehmungen und Löcher 5,6,8 auf. Wie aus der Figur leicht zu ersehen ist, sind die Ausnehmungen und Löcher 5,6,8 in den Vorsprüngen 4 jeweils identisch. Der Lochabstand zwischen benachbarten Vorsprüngen 4 entspricht im wesentlichen dem Abstand der Einschübe.

Die Ausnehmung 5 ist als Zentrierloch ausgebildet. Beim Einschieben der Baugruppe, die in der Zeichnung nicht dargestellt ist, bildet das Zentrierloch 5 eine Aufnahme für einen Führungs- und Kontaktstift der Baugruppe. Beim Einschieben der Baugruppe kommt die Mantelfläche des Führungs- und Kontaktstiftes der Baugruppe mit der Innenfläche des Zentrierloches 5 in Kontakt, bevor die Steckverbindung der Rückwand- bzw. Zwischenwandleiterplatte zum Eingriff kommt. Diese voreilende Kontaktierung schützt empfindliche elektronische Bauelemente auf der Platine des Einschubs vor elektrostatischen Einflüssen.

Die Ausnehmungen 6 sind viereckig und bilden (in der Zeichnung nicht näher dargestellte) Kodierungskammern. Die Kodierungskammern lassen das Einstecken einer Baugruppe an einem Steckplatz nur dann zu, wenn die Schlüssel-Schloss-Konfiguration übereinstimmt.

Ferner ist an jedem Vorsprung 4 eine zur Baugruppe hin geöffnete Ausbrechung 8 ausgestanzt. Diese Ausbrechung 8 ist Teil einer Kontakteinrichtung. Diese Kontakteinrichtung, die in der Zeichnung nicht näher dargestellt ist, kann beispielsweise durch eine Bügelkontaktfeder gebildet sein, die in Ausbrechung aufgerastet ist. Beim Einschieben einer Baugruppe stellt die Kontakteinrichtung zwischen einer Entladungsleiterbahn auf der Leiterplatte und dem Baugruppenträger einen elektrischen Kontakt her. Dieser Potentialausgleich erweitert den Schutz für die elektronischen Bauteile auf der Leiterplatte, da auch im Fall einer elektrostatischen Aufladung der Leiterplatte, die elektrische Ladung kontrolliert abgeleitet wird.

Ein anderer Teil der Profilierung 3 wird durch parallel und in Einschubrichtung 15 verlaufende Vorsprünge 7 gebildet. Diese Vorsprünge 7 ragen in den Einbauraum 11. Im Innenraum 11 jeweils paarweise gegenüberliegende Vorsprünge 7 bilden eine Längsführung für die Baugruppe, die das Einschieben und Einstecken der Baugruppe erleichtert.

Der Führungsrost 1 setzt sich zur Frontseite hin in einer Winkelleiste 12 fort. Ein Schenkel 13 der Winkelleiste 12 bildet in einer eingeschobenen Position einer Baugruppe eine Anschlagfläche 14 für die Innenfläche der Frontplatte. Die Frontplatte selbst ist in der Zeichnung nicht dargestellt. Im Schenkel 13 sind Gewindelöchern 10 für Befestigungsschrauben vorgesehen, mittels derer die Frontplatte mit dem Baugruppenträger verschraubt werden kann. Jedem Gewindeloch 10 ist ein Zentrierloch 5 zugeordnet, das in Verbindung mit dem oben erwähnten Führungs- und Kontaktstift auf der Baugruppe eine Vorzentrierung beim Einstecken der Baugruppe herstellt. Dadurch befindet sich die Baugruppe beim Einschieben in einer präzisen Steckposition, bevor ein elektrischer Kontakt zwischen Steckverbinderstiften auf der Rückwandleiterplatte bzw. Zwischenwandleiterplatte und der Leiterplatte des Baugruppenträgers hergestellt wird.

Der gegenläufig zur Einschubrichtung 15 sich erstreckende Schenkel 16 ist mit Durchbrüchen 17 versehen. In diese Durchbrüche 17 greift der Steck- bzw. Ziehhebelmechanismus der eingeschobenen Baugruppe ein, um die Baugruppe in der Einschubposition zu sichern bzw. diese aus der Einschubposition auszuheben.

Die Winkelleiste 12 und die in Reihe liegenden Vorsprünge 4 bilden baugruppenträgerseitig die Kontakt- und Verbindungsvorrichtung 2, die bisher aus verschiedenen, vom Baugruppenträger getrennten, einzelnen Konstruktionselementen bestand. Durch die erfindungsgemäße Konstruktion ist die Kontakt- und Verbindungsvorrichtung 2 nun integraler Bestandteil des Führungsrostes. Unter fertigungstechnischen Gesichtpunkten ist diese Konstruktion sehr vorteilhaft, da Herstellung und Montage mit vergleichsweise geringem Aufwand möglich ist.

Um Wärme von den Baugruppen abzuführen, ist der Führungsrost 1 mit Öffnungen 9 versehen, die Durchtrittsöffnungen für Kühlluft bilden.

### Zusammenstellung der Bezugszeichen

- 1: Führungsrost
- 2: Kontakt- und Verbindungsvorrichtung (baugruppenseitig)
- 3: Profilierung
- 4: Erste Vorsprünge (quer zur Einschubrichtung)
- 5: Ausnehmung (Zentrierloch)
- 6: Ausnehmung (Kodierkammer)
- 7: Zweite Vorsprünge(Längsführung in Einschubrichtg.)
- 8: Ausbrechung
- 9: Öffnung
- 10: Gewindeloch
- 11: Einbauraum
- 12: Winkelleiste
- 13: Schenkel
- 14: Anschlagfläche
- 15: Einschubrichtung
- 16: Schenkel in Einschubrichtung
- 17: Durchbruch
- 18: Einschuböffnung

## Patentansprüche

1. Baugruppenträger für auf Führungsrosten (1) vorderseitig und/oder rückseitig in einen Einbauraum (11) einschiebbare Baugruppen, wobei die Führungsroste (1) gegenüberliegende Begrenzungswände des Einbauraums (11) bilden und jeweils baugruppenträgerseitige Kontakt- und Verbindungsvorrichtung umfassen, **gekennzeichnet durch** folgende Merkmale:
- die Führungsroste (1)sind einstückig ausgebildet und weisen eine integrierte Profilierung (3) auf, die in den Einbauraum (11) ragt und erste Vorsprünge (4) umfasst, die sich quer zur Einschubrichtung (15) erstrecken,
- die ersten Vorsprünge (4) sind in Einschubrichtung (15) gesehen **durch** eine Reihe von Ausnehmungen und Löchern (5, 6, 8) durchbrochen, in welche, in eingesteckter Stellung einer Baugruppe, eine baugruppenseitge Kontakt- und Verbindungsvorrichtung eingreift.

2. Baugruppenträger nach Anspruch 1,
**dadurch gekennzeichnet,**
**dass** die ersten Vorsprünge (4) im Bereich des Randes der Einschuböffnung (18) fluchten angeordnet sind.

3. Baugruppenträger nach Anspruch 1 oder 2,
**dadurch gekennzeichnet,**
**dass** einem Steckplatz einer Baugruppe an jedem Führungsrost (1) jeweils ein erster Vorsprung (4) zugeordnet ist.

4. Baugruppenträger nach Anspruch 3,
**dadurch gekennzeichnet,**
**dass** jeder Vorsprung (4) eines Steckplatzes folgende Ausnehmungen aufweist:
- ein Zentrierloch (5), das in eingesteckter Stellung der Baugruppe eine Aufnahme für einen baugruppenseitigen zylindrischen Kontaktstift bildet,
- rechteckförmige Durchbrechungen (6), die als Kodierungskammern ausgebildet sind und beim Einstecken mit einer Baugruppenkodierung so zusammenwirken, dass Baugruppen funktional bestimmten Steckplätzen zugeordnet werden,
- eine zur Baugruppe hin geöffnete Ausbrechung (8), die beim Einschieben der Baugruppe und vor dem Eingriff der Steckverbinderstift eine Entladungsleiterbahn der Leiterplatte kontaktiert, um die Baugruppe vor elektrostatischen Entladungen zu schützen.

5. Baugruppenträger nach einem der vorstehenden Ansprüche,
**dadurch gekennzeichnet,**
**dass** die Profilierung (3) zweite Vorsprünge (7) umfasst, die sich längs der Einschubrichtung (15) erstrecken und so ausgebildet sind, dass sie beim Einstecken die Baugruppe seitlich führen.

6. Baugruppenträger nach einem der vorstehenden Ansprüche,
**dadurch gekennzeichnet,**
**dass** jeder Führungsrost (1) einschubseitig in eine L-förmige Winkelleiste fortgesetzt ist, wobei ein in Ebene der Einschuböffnung (18) liegender Schenkel eine Anschlagfläche (14) für die Frontplatte der Baugruppe bildet und ein sich in Einschubrichtung (15) erstreckender Schenkel (16) Durchbrüche (17) aufweist, in welche in eingesteckter Stellung ein Steck- und Ziehhebel der Baugruppe eingreift.

7. Baugruppenträger nach Anspruch 6,
**dadurch gekennzeichnet,**
**dass** die Anschlagfläche (14) Gewindelöcher (10) für baugruppenseitige Befestigungsschrauben aufweist.

8. Baugruppenträger nach einem der vorstehenden Ansprüche,
**dadurch gekennzeichnet,**
**dass** die Führungsroste (1) einstückig und materialeinheitlich als Biege-Stanzteil aus Blech gebildet sind.

9. Baugruppenträger nach einem der vorstehenden Ansprüche,
**dadurch gekennzeichnet,**
**dass** die Führungsroste (1) aus einem korrosionsgeschützten Blech hergestellt sind.

## Claims

1. Subrack for modules which can be inserted into an installation space (11) from the front end and/or from the rear end on guide racks (1), it being possible for the guide racks (1) to form opposing boundary walls of the installation space (11), and for each to contain subrack contacting and connecting devices, **characterised by** the following features:
- the guide racks (1) are constructed as one piece and have an integrated profiling (3) that projects into the installation space (11) and contains first projections (4) that extend transversely to the direction of insertion (15),
- the first projections (4), viewed in the direction of insertion (15), are perforated by a row of recesses and holes (5, 6, 8) with which a module's contacting and connecting device is engaged in the inserted position of a module.

2. Subrack according to claim 1,
**characterised in that**
the first projections (4) are aligned in the edge region of the insertion opening (18).

3. Subrack according to claim 1 or 2,
**characterised in that**,
at each guide rack (1) a first projection (4) is assigned in each case to a module location of a module.

4. Subrack according to claim 3,
**characterised in that**,
each projection (4) of a module location has the following recesses:
- a locating hole (5) that, in the inserted position of the module, forms a receptacle for a cylindrical contact/guide pin of the module,
- rectangular through-holes (6) that are constructed as coding chambers and during the plugging-in operation co-operate with a module coding so that modules can be assigned to function-specific module locations,
- a slot (8) opening towards the module, which at the insertion of the module and before the engagement of the connector pin, makes contact with the discharge conductor track of the printed-circuit board in order to protect the module from electrostatic discharges.

5. Subrack according to one of the preceding claims,
**characterised in that**,
the profiling (3) has second projections (7) that extend along the direction of insertion (15) and are constructed so that on insertion they guide the module in a lateral manner.

6. Subrack according to one of the preceding claims,
**characterised in that**,
each guide rack (1) is extended at the insertion end by an L-shaped angle strip, it being possible for an arm positioned in the plane of the insertion opening (18) to form a stop face (14) for the front panel of the module and for an arm (16) extending in the direction of insertion (15) to have through-holes (17) with which, in the inserted position, an injector/extractor lever of the module engages.

7. Subrack according to claim 6,
**characterised in that**,
the stop face (14) has threaded holes (10) for the module's setscrews.

8. Subrack according to one of the preceding claims,
**characterised in that**,
the guide racks (1) are formed from sheet metal as a bent/stamped part from one piece of the same material.

9. Subrack according to any one of the preceding claims,
**characterised in that**,
the guide racks (1) are manufactured from a corrosion-proof metal sheet.

## Revendications

1. Support d'ensembles pour des ensembles pouvant être introduits sur des grilles de guidage (1) côté avant et/ou côté arrière dans un espace de montage (11), les grilles de guidage (1) formant des parois de délimitation se faisant face de l'espace de montage (11) et comprenant à chaque fois un dispositif de contact et de liaison côté support d'ensembles, **caractérisé par** les caractéristiques suivantes:
- les grilles de guidage (1) sont conçues d'une seule pièce et présentent un profilage (3) intégré, qui dépasse dans l'espace de montage (11) et comporte des premières saillies (4) qui s'étendent transversalement au sens d'introduction (15),
- les premières saillies (4) sont traversées, vu dans le sens d'enfichage (15), par une série d'évidements et les trous (5, 6, 8), dans lesquels s'engage un dispositif de contact et de liaison côté ensemble, lorsqu'un ensemble est dans la position emboîtée.

2. Support d'ensembles selon la revendication 1,
**caractérisé en ce que**
les premières saillies (4) sont disposées en alignement dans la zone du bord de l'ouverture d'introduction (18).

3. Support d'ensembles selon la revendication 1 ou 2,
**caractérisé en ce que**
à chaque fois une première saillie (4) est attribuée à un slot d'un ensemble sur chaque grille de guidage (1).

4. Support d'ensembles selon la revendication 3,
**caractérisé en ce que**
chaque saillie (4) d'un slot présente les évidements suivants:
- un trou de centrage (5), qui, lorsque l'ensemble est dans la position emboîtée, forme un logement pour une broche de contact cylindrique côté ensemble,
- des percements (6) rectangulaires, qui sont réalisés sous forme de chambres de codage et qui interagissent lors de l'emboîtement avec un codage d'ensemble de telle sorte que des ensembles sont attribués à des slots définis au plan fonctionnel,
- un percement (8) ouvert en direction de l'ensemble, qui, lors de l'introduction de l'ensemble et avant l'engagement de la broche de connecteur, établit un contact avec une piste conductrice de décharge de la plaquette de circuits imprimés, afin de protéger l'ensemble de décharges électrostatiques.

5. Support d'ensembles selon l'une quelconque des revendications précédentes,
**caractérisé en ce que**
le profilage (3) comporte des secondes saillies (7) qui s'étendent le long de la direction d'introduction (15) et sont réalisées de telle sorte qu'elles guident latéralement l'ensemble lors de l'enfichage.

6. Support d'ensembles selon l'une quelconque des revendications précédentes,
**caractérisé en ce que**
chaque grille de guidage (1) est prolongée côté introduction en une baguette d'angle en L, une branche située dans le plan de l'ouverture d'introduction (18) formant une surface de butée (14) pour la plaque avant de l'ensemble et une branche (16) s'étendant dans le sens d'introduction (15) présentant des percements (17) dans lesquels s'engage dans la position emboîtée un levier d'enfichage et d'extraction de l'ensemble.

7. Support d'ensembles selon la revendication 6,
**caractérisé en ce que**
la surface de butée (14) présente des trous de filetage (10) pour des vis de fixation côté ensemble.

8. Support d'ensembles selon l'une quelconque des revendications précédentes,
**caractérisé en ce que**
les grilles de guidage (1) sont conçues d'une seule pièce et de façon homogène au niveau du matériau sous forme de pièce pliée et estampée en tôle.

9. Support d'ensembles selon l'une quelconque des revendications précédentes,
**caractérisé en ce que**
les grilles de guidage (1) sont fabriquées dans une tôle protégée contre la corrosion.
